# DEMANDE DE BREVET EUROPEEN

(11) **EP 2 610 915 A1**
(43) Date de publication de la demande: **03.07.2013**
(21) Numéro de dépôt: 12198475.1
(22) Date de dépôt: 20.12.2012
(51) Int. Cl.: H01L 29/786, H01L 29/66, H01L 29/45, H01L 29/78

(54) **Transistor et procédé de fabrication d'un transistor**

(30) Priorité: 27.12.2011 FR 1162481
(71) Demandeur: COMMISSARIAT A L'ENERGIE ATOMIQUE ET AUX ENERGIES ALTERNATIVES, 75015 Paris (FR)
(72) Inventeur: Posseme, Nicolas, 29660 CARANTEC (FR); Grenouillet, Laurent, 38140 RIVES (FR); Le Tiec, Yannick, 38920 CROLLES (FR); Vinet, Maud, 38140 RIVES (FR)
(74) Mandataire: Hautier, Nicolas

(57) **Abrégé**

L'invention décrit un transistor comprenant au moins : une couche active (116) formant un canal (180) pour le transistor, une couche isolante (114) disposée au regard d'une face inférieure de la couche active (116), une grille (124) tournée au regard d'une face supérieure de la couche active (116) et une source et un drain (140) disposés de part et d'autre de la grille (124), **caractérisé en ce qu**'au moins l'un parmi la source et le drain (140) s'étend au moins partiellement à travers la couche active (116) et dans la couche isolante (114).

L'invention décrit également un dispositif microélectronique et un procédé de réalisation du transistor.

## Description

### DOMAINE TECHNIQUE DE L'INVENTION

La présente invention concerne en général les transistors de type métal oxyde semi-conducteur à effet de champs (MOSFET) et plus particulièrement la réduction d'éléments parasites limitant leur vitesse de fonctionnement.

### ÉTAT DE LA TECHNIQUE

L'intégration toujours croissante d'un plus grand nombre de composants élémentaires dans les circuits intégrés produits par l'industrie de la microélectronique conduit à devoir continûment réduire leur taille. Le composant de base typique d'un très grand nombre de circuits intégrés est un transistor de structure métal-oxyde-semiconducteur ou MOS, de type à effet de champs ou FET, acronyme de l'anglais « field effect transistor ». Dans un transistor MOSFET on fait circuler un courant entre une électrode « source » et une électrode « drain » sous le contrôle d'une « grille » de commande qui crée un canal de conduction entre source et drain dès qu'une tension suffisante y est appliquée. La vitesse de commutation maximale d'un transistor MOSFET dépend de la vitesse avec laquelle on peut effectivement établir et faire disparaître le courant de conduction. Elle dépend, entre autres, de nombreux paramètres physiques propres aux matériaux utilisés comme, par exemple, la mobilité des porteurs du matériau semi-conducteur employé et les niveaux et type de dopage des différentes zones définissant les électrodes. La vitesse de commutation dépend aussi largement de la géométrie et de la structure des transistors. Notamment, par l'intermédiaire des éléments parasites qui sont inévitablement introduits par la réalisation pratique de ces dispositifs. Deux éléments parasites particulièrement critiques sont, d'une part, la résistance série d'accès des électrodes source et drain, et la capacité parasite entre grille et source ou drain d'autre part. Ces éléments parasites forment une constante de temps qui contribue à limiter la vitesse de commutation maximale de tout transistor.

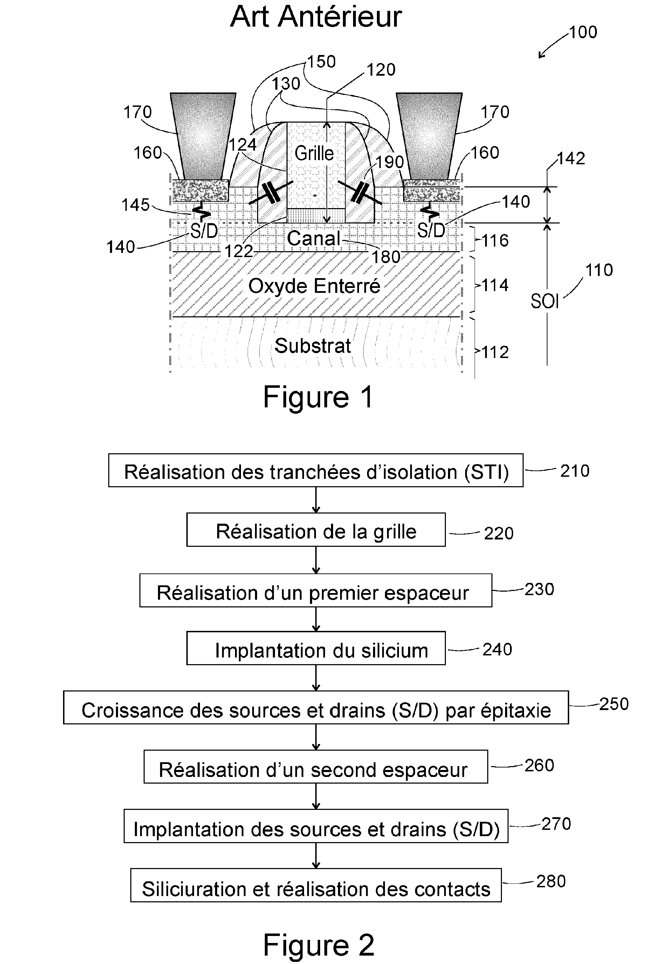

La **figure 1** montre une vue en coupe d'un transistor MOSFET 100 caractéristique de l'état actuel de la technique. Le plus souvent les circuits intégrés sont actuellement réalisés à partir de substrats élaborés de type dit SOI, acronyme de l'anglais « silicon on insulator », c'est-à-dire « silicium sur isolant » et plus généralement « semi-conducteur sur isolant ». Dans la figure 1 on retrouve le substrat SOI 110 d'origine qui est constitué d'un substrat initial 112, le plus souvent une tranche homogène de silicium, et d'une couche d'oxyde enterrée 114 qui assure l'isolation des composants qui seront fabriqués dans la fine couche superficielle 116 de semi-conducteur présente sur la couche enterrée. La couche superficielle 116 est constituée le plus souvent du silicium monocristallin. L'isolation de chacun des transistors 100 est complétée par la réalisation de tranchées latérales d'isolation dites STI, acronyme de l'anglais « shallow trench isolation » c'est-à-dire « tranchées d'isolation peu profondes ». Elles atteignent la couche d'oxyde enterrée pour englober chacun des transistors dans une couche continue d'oxyde. Ces tranchées, qui ne sont pas nécessaires à la compréhension de l'invention, ne sont pas représentées.

La **figure 2** résume les principales étapes standard de fabrication d'un transistor MOSFET représentatif de l'état de la technique. Les étapes décrites brièvement ci-après mettent en oeuvre des méthodes et moyens qui sont constamment développés et améliorés depuis des décennies par l'industrie de la microélectronique et notamment la photolithographie pour la définition des motifs. La première étape 210 consiste à réaliser, à partir du substrat SOI 110 d'origine, les tranchées d'isolation STI mentionnées ci-dessus qui vont permettre d'assurer l'isolation complète de chacun des transistors 100. À l'étape globale suivante 220 on réalise l'empilement de couches et les motifs qui vont constituer la grille 120 de chaque transistor comprenant deux couches essentielles : l'oxyde mince de grille 122 et la grille de commande 124 proprement dite. Cette dernière est généralement faite de silicium polycristallin conducteur qui joue le rôle du métal dans la structure MOS du transistor ou d'un empilement de couches constitué d'un métal et de polysilicium. À l'étape suivante 230, on réalise une première couche d'espaceurs 130 sur les flancs de chaque motif de grille. Les espaceurs, faits de nitrure de silicium, et la grille elle-même, vont servir à protéger le canal 180 lors d'une première opération d'implantation de la couche superficielle de silicium qui va suivre. On notera ici que les espaceurs et les sources et drains sont réalisés sans mettre en oeuvre aucune opération de photolithographie. Comme mentionné ci-dessus une première implantation 240 des zones de source et drain 140 dans la couche superficielle 116, généralement faite de silicium monocristallin, est ensuite effectuée. On remarquera que source et drain sont identiques, ils ont une même structure physique et géométrique. Seules leurs interconnexions avec d'autres transistors et les tensions qui seront appliquées dans le dispositif électronique en cours de réalisation vont pouvoir permettre d'attribuer finalement le rôle de source ou de drain à l'une ou l'autre des électrodes. Dans la description qui suit de l'invention les électrodes source et drain sont donc indifférenciées et référencées par un même acronyme « S/D » 140.

L'étape suivante 250 du procédé standard de réalisation d'un transistor conforme à la figure 1 consiste à accroître l'épaisseur 142 des zones source et drain (S/D). Opération dont le but principal est de réduire les résistances 145 d'accès de ces électrodes. L'épaississement des zones S/D se fait classiquement par croissance épitaxiale à partir de la couche sous jacente, c'est-à-dire la couche 116 de silicium monocristallin du substrat SOI d'origine. Il s'agit donc de diminuer l'un des éléments parasites mentionnés précédemment qui viennent limiter la vitesse de commutation et les performances des transistors. Comme on constate que la résistance d'accès est inversement proportionnelle à l'épaisseur des S/D on notera ici qu'il y a tout intérêt pour réduire significativement cet élément parasite à augmenter la surélévation des S/D. Ce type de transistor et de procédé est souvent qualifié de « RSD », acronyme de l'anglais « raised source drain » c'est-à-dire « source drain surélevés ».

Les autres opérations standard consistent en une étape 260 de réalisation d'une seconde couche d'espaceurs 150. Cette seconde couche d'espaceurs sert à limiter latéralement, autour du motif de grille, les zones de siliciuration qui permettent d'assurer un bon contact électrique avec le silicium des S/D 140 surélevés. La siliciuration 160 et les contacts métalliques 170 sont formés à l'étape 280. Préalablement, à l'étape 270, une seconde implantation des S/D est réalisée qui assure un dopage de ces zones. Comme pour les S/D on notera qu'une siliciuration de la partie haute de la grille 120 faite de silicium polycristallin est également réalisée pour qu'on puisse aussi établir un bon contact électrique sur cette électrode. Par souci de clarté le contact de grille et sa zone siliciurée ne sont cependant pas représentés sur la figure 1.

L'autre élément parasite mentionné précédemment est la capacité 190 entre les S/D et la grille. Les espaceurs constituent le diélectrique de cette capacité. La capacité parasite due aux espaceurs tend à augmenter proportionnellement à l'accroissement d'épaisseur 142 de la couche épitaxiale de surélévation des S/D 140. On constate ainsi que dans le procédé standard de réalisation des MOSFET qui vient d'être brièvement décrit, les conditions d'optimisation des éléments parasites principaux qui limitent leur vitesse de commutation sont parfaitement antagonistes puisque que pour diminuer l'un, la résistance d'accès des source et drain 140, il faut augmenter la surélévation de ces derniers ce qui entraîne une augmentation de l'autre élément parasite, c'est-à-dire la capacité 190 entre la grille et les source et drain 140.

Pour compenser l'augmentation de la capacité parasite entre la grille et les S/D 140, différentes techniques ont été proposées. Une première méthode consiste à utiliser des espaceurs dont le matériau est à plus faible permittivité que celui du nitrure de silicium actuellement utilisé. Par exemple, le remplacement du nitrure par de l'oxyde de silicium permet de réduire significativement la valeur de la capacité parasite.

Le remplacement du nitrure complique cependant sérieusement le procédé standard de fabrication des transistors MOSFET. Ce remplacement peut être obtenu en prévoyant des étapes supplémentaires au cours desquelles on retire finalement le nitrure qui a servi normalement de protection pour permettre l'auto alignement des S/D sur la grille comme expliqué précédemment. Le nitrure est alors remplacé, dans le dispositif final, par de l'oxyde de silicium avec l'avantage d'une diminution de la capacité parasite 190. Cette solution a donc pour inconvénient de rajouter au procédé standard des étapes additionnelles et délicates.

Le procédé standard peut aussi être modifié en prévoyant d'utiliser directement des espaceurs en oxyde de silicium. Ce matériau se prête cependant beaucoup moins bien que le nitrure à la réalisation des espaceurs et il n'existe pas actuellement de procédé industriellement fiable qui permette un remplacement direct du nitrure.

Une autre méthode qui a aussi été expérimentée consiste en ce que la croissance épitaxiale qui permet l'obtention de S/D surélevés afin de diminuer la résistance d'accès de ces électrodes, soit réalisée en limitant la croissance latérale de cette épitaxie afin d'éloigner les zones S/D 140 de la grille et donc de diminuer la capacité parasite 190 en augmentant l'épaisseur de diélectrique entre ces zones. Cette technique dite « épitaxie facettée » est cependant particulièrement difficile à maîtrisée. L'épaisseur de silicium déposée lors de la croissance d'une épitaxie facettée est très sensible à l'environnement. Ainsi, il y a des disparités d'épaisseur entre dispositifs larges et étroits qui peuvent induire des dysfonctionnements comme une siliciuration totale et l'apparition de courants de fuite qui nuisent gravement à la fiabilité des dispositifs. On constate également des disparités d'épaisseur entre les zones où la densité de motifs est grande et celles où elle est faible.

De cette brève présentation des procédés connus de réalisation des transistors MOSFET, il ressort ainsi clairement qu'aucune solution connue ne permet de réduire à la fois la résistance d'accès des électrodes source et drain et à la fois la capacité parasite entre ces électrodes et la grille de commande et ceci tout en proposant un procédé de fabrication relativement simple et fiable.

La présente invention a pour objectif de proposer une solution qui réponde à certaines au moins de ces contraintes.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un objet de la présente invention concerne un transistor comprenant au moins : une couche active formant un canal pour le transistor, une couche isolante disposée au regard d'une face inférieure de la couche active, une grille tournée au regard d'une face supérieure de la couche active et une source et un drain disposés de part et d'autre de la grille. Au moins l'un parmi la source et le drain s'étend au moins partiellement à travers la couche active et dans la couche isolante. Une partie au moins du drain et/ou de la source est donc enterrée dans la couche isolante et s'étend sous la face inférieure de la couche active.

De manière optionnelle mais néanmoins avantageuse, à la fois la source et le drain traversent la couche active et s'étendent dans la couche isolante. Ainsi, le transistor présente une structure très particulière dans laquelle la source et/ou le drain sont inversés par rapport aux structures connues, c'est-à-dire qu'ils sont enterrés dans la couche d'isolante sous jacente au canal. Cette structure permet de réduire la capacité parasite entre la grille et la source le drain. En outre elle permet d'épaissir la source et le drain selon une direction perpendiculaire au plan du substrat ce qui a pour effet de réduire la résistance d'accès des électrodes de la source et du drain.

De manière également avantageuse, l'invention permet de rendre indépendante la hauteur de la grille par rapport à la hauteur des source et drain, ce qui permet notamment de réduire la hauteur de la grille.

De manière facultative, le transistor selon l'invention peut en outre comprendre au moins l'une quelconque des caractéristiques mentionnées ci-dessous :

Avantageusement, la source et le drain s'étendent dans la couche isolante depuis la face supérieure de la couche active.

De préférence, l'au moins un parmi la source et le drain qui traverse la couche active et s'étend dans la couche isolante depuis la face supérieure de la couche active présente une épaisseur comprise entre 3 et 50 nm (nanomètres), l'épaisseur étant prise selon une direction perpendiculaire au plan du substrat.

Préférentiellement, la grille et l'au moins un parmi la source et le drain sont disposés de part et d'autre de la face supérieure de la couche active.

Avantageusement, l'au moins un parmi la source et le drain présente une face supérieure située en dessous d'une face inférieure de la grille. Comme cela sera explicité plus bas et illustré sur les figures, la face supérieure de la source et/ou du drain est entièrement située sous une face inférieure de la grille. Ainsi, selon une direction parallèle au plan du substrat, la source et le drain ne sont pas au regard de la grille. Avantageusement, ni la source ni le drain ne présente de surface en regard avec la grille selon une direction parallèle au plan du substrat. Cela permet de limiter les surfaces en regard de la grille avec la source et/ou avec le drain, entraînant avantageusement une réduction de la capacité parasite.

Avantageusement, au moins l'un parmi la source et le drain présente une hauteur inférieure à l'épaisseur de la couche isolante, la hauteur étant comptée depuis la face inférieure de la couche active ou du canal. La hauteur et l'épaisseur de la couche active sont prises selon une direction sensiblement perpendiculaire au plan du substrat. De préférence, l'un parmi la source et le drain présente une hauteur inférieure à l'épaisseur de la couche isolante moins deux nanomètres. Préférentiellement, à la fois la source et le drain présentent une hauteur inférieure à l'épaisseur de la couche isolante moins deux nanomètres.

Ainsi, au moins parmi la source et le drain présente une hauteur inférieure à l'épaisseur de la couche isolante. Ainsi, les S/D ne traversent pas entièrement la couche isolante. L'invention permet ainsi de conserver une isolation électrique entre les S/D et le substrat.

Typiquement, l'épaisseur d'une couche isolante de type couche d'oxyde enterrée souvent désignée par l'acronyme BOX signifiant buried oxyde est de 25 nm, l'épaisseur de la source et/ou du drain étant alors inférieure à 23 nm. De préférence, la hauteur de la source et/ou du drain est comprise entre 1 nm et l'épaisseur de la couche isolante moins deux nanomètres.

De préférence, l'au moins un parmi la source et le drain qui s'étend sous la couche inférieure de la couche active ne s'étend pas dans le substrat.

De préférence, l'au moins un parmi la source et le drain qui traverse la couche active et s'étend dans la couche isolante présente une portion au regard de la grille selon une direction parallèle au plan du substrat, la hauteur de ladite portion selon une direction perpendiculaire au plan du substrat étant inférieure à 0.3 fois la hauteur de la grille.

De préférence cette hauteur est inférieure à 0.1 fois la hauteur de la grille.

Selon cette alternative, la source et/ou le drain présente une portion en regard, mais la dimension de cette portion par rapport à la grille est très limitée, réduisant de ce fait la capacité parasite par rapport aux solutions connues.

De préférence, l'au moins un parmi la source et le drain présente une hauteur comprise entre 0.2 et 1 fois la hauteur de la grille. La hauteur est prise selon une direction sensiblement perpendiculaire au plan du substrat (ou plan de toute autre couche). De préférence, la largeur de l'au moins un parmi la source et le drain au niveau de la couche isolante est comprise entre 1,2 et 5 fois la largeur au niveau de la couche active et de préférence entre 1,5 et 5 fois la largeur au niveau de la couche active. Plus généralement, l'au moins un parmi la source et le drain présente, selon des directions sensiblement parallèle au plan du substrat, une largeur au niveau de la couche active inférieure à la largeur au niveau de la couche isolante.

De préférence, le transistor comprend une couche de protection recouvrant la couche active et la grille à l'exception de zones de contact électriques.

Préférentiellement, le transistor est de type MOSFET comprenant une seule grille. La couche isolante est une couche d'oxyde enterrée et la couche active est une couche de silicium monocristallin.

Selon un mode de réalisation avantageux, la couche isolante est disposée au contact de la face inférieure de la couche active. Préférentiellement, la couche de protection est disposée sur la face supérieure de la couche active et de préférence directement à son contact. Elle recouvre ainsi la couche active. Dans un mode de réalisation avec une couche de protection formée après réalisation des sources et drains, la couche de protection est de préférence soit au contact de la couche active, soit au contact d'une couche d'arrêt, cette dernière étant alors au contact de la face supérieure de la couche active. De préférence, la couche d'oxyde de grille est disposée au contact de la couche active.

Un autre objet de la présente invention concerne un dispositif microélectronique comprenant une pluralité de transistors selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

Un autre objet de la présente invention concerne un procédé de fabrication d'un transistor comprenant la préparation d'un empilement de couches comportant au moins un substrat de support surmonté d'une couche isolante et d'une couche active destinée à former un canal pour le transistor, la couche active étant destinée à être surmontée d'une grille de commande du transistor, le procédé comprenant en outre la préparation d'une source et d'un drain disposés de part et d'autre de la grille, le procédé étant **caractérisé en ce que** la préparation de la source et du drain comprend: le dépôt d'une couche de protection recouvrant au moins la couche active; la formation d'ouvertures à travers la couche de protection et la couche active pour mettre à nu la couche isolante au niveau de zones destinées à former la source et le drain; la formation d'une cavité dans la couche isolante au fond des ouvertures; le remplissage des cavités par un matériau semi-conducteur pour former au moins en partie au moins l'un parmi la source et le drain du transistor.

Ce procédé permet ainsi de former des source et drain inversés et épais, réduisant de ce fait les résistances et les capacités parasites. Avantageusement, ce procédé est relativement simple à mettre en oeuvre. Il présente en outre une bonne fiabilité et une bonne reproductibilité.

De manière facultative, le procédé selon l'invention peut en outre comprendre au moins l'une quelconque des caractéristiques et étapes mentionnées ci-dessous :

De préférence, l'étape de formation d'une cavité dans la couche isolante est réalisée de sorte à former une cavité dont la profondeur, selon une direction perpendiculaire au plan du substrat et prise à partir de la face inférieure de la couche isolante surmontée de la couche active est comprise entre 1nm et Tbox-2nm, Tbox étant l'épaisseur de la couche isolante. De préférence, la partie des source et drain qui s'étend de manière isotrope sous les espaceurs n'est pas plus large que les espaceurs.

De préférence, la largeur de la cavité est sensiblement égale à la hauteur de la cavité prise à partir d'une face inférieure de la couche active.

Préférentiellement, les cavités ne s'étendent pas au-delà des espaceurs, c'est-à-dire que les cavités ne sont pas présentes à l'aplomb des espaceurs. Ainsi les cavités sont distantes des espaceurs et des flancs de la grille selon une direction perpendiculaire aux flancs de la grille. Autrement dit, les cavités sont formées de manière à ce que les extrémités latérales de la cavité soient distantes de l'aplomb des flancs de la grille.

De préférence, le remplissage est effectué de manière à remplir entièrement la cavité. Ainsi le matériau formant les S/D est au contact de la couche isolante selon une direction perpendiculaire aux flancs de la grille.

De préférence, la couche active est faite d'un matériau semi-conducteur et le remplissage des cavités est effectué par épitaxie de la couche active. La couche active est en silicium monocristallin.

Avantageusement, au cours de la formation des ouvertures, on pratique une ouverture au droit d'une zone destinée à former la source et une ouverture au droit d'une zone destinée à former le drain.

De préférence, on procède à la siliciuration de contacts au niveau de la source et du drain.

Selon un mode de réalisation, la couche de protection est conservée au cours de toutes les étapes du procédé. Selon un autre mode de réalisation, le procédé comprend en outre après l'étape de remplissage des cavités par un matériau semi-conducteur : l'enlèvement de la couche de protection ; le dépôt d'au moins une couche d'isolation électrique sur l'ensemble de l'empilement de couches; l'ouverture de zones de contact au moins au niveau de la source et du drain.

De préférence, le procédé comprenant en outre une étape de siliciuration des zones de contact.

Selon un mode de réalisation, le dopage de la source et du drain est obtenu in situ lors du remplissage des cavités. Selon un autre mode de réalisation, on procède au dopage de la source et du drain à l'aide d'une implantation ionique après l'étape de remplissage des cavités.

De préférence, on pratique un recuit de diffusion de la source et du drain.

Préférentiellement, l'empilement de couches comprenant le substrat, la couche isolante et la couche active est un substrat de type semi-conducteur sur isolant (SOI). Le substrat SOI comprend une couche active superficielle de silicium monocristallin sur une couche enterrée d'oxyde de silicium d'une épaisseur compatible avec la taille des cavités creusées pour y former les source et drain inversés.

De préférence, le matériau constituant la couche de protection est de l'oxyde de silicium dopé au carbone (SiOCH) ou du carbone amorphe (APF). Plus généralement, la couche de protection est faite d'un matériau résistant au produit de gravure des cavités.

Selon un mode de réalisation, la préparation de la source et du drain est effectuée après une étape de formation d'une grille de commande du transistor, la grille surmontant la couche active. Selon un mode de réalisation alternatif, la préparation de la source et du drain est effectuée avant une étape de formation d'une grille de commande du transistor, la grille surmontant la couche active. On évite ainsi de soumettre la grille aux contraintes, thermiques notamment, lors des différentes étapes de fabrication des autres éléments du transistor et le budget thermique de la grille est ainsi préservé.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 montre une vue en coupe d'un transistor MOSFET caractéristique de l'état actuel de la technique.
La FIGURE 2 résume les principales étapes standard de fabrication d'un transistor MOSFET représentatif de l'état de la technique.
Les FIGURES 3a à 3c illustrent les étapes du procédé de l'invention qui sont identiques à celles du procédé standard de fabrication de transistors MOSFET.
Les FIGURES 4a à 4e illustrent les étapes spécifiques à l'invention du procédé de fabrication de transistors MOSFET, la figure 4e illustrant un exemple de transistor selon l'invention une fois finalisé.
Les FIGURES 5a et 5b décrivent des variantes de mise en oeuvre du procédé de l'invention, la figure 5b illustrant un exemple de transistor selon l'invention une fois finalisé.
La FIGURE 6 résume les principales étapes de fabrication d'un transistor MOSFET selon le procédé de l'invention.

Les dessins joints sont donnés à titre d'exemples et ne sont pas limitatifs de l'invention.

### DESCRIPTION DÉTAILLÉE DE L'INVENTION

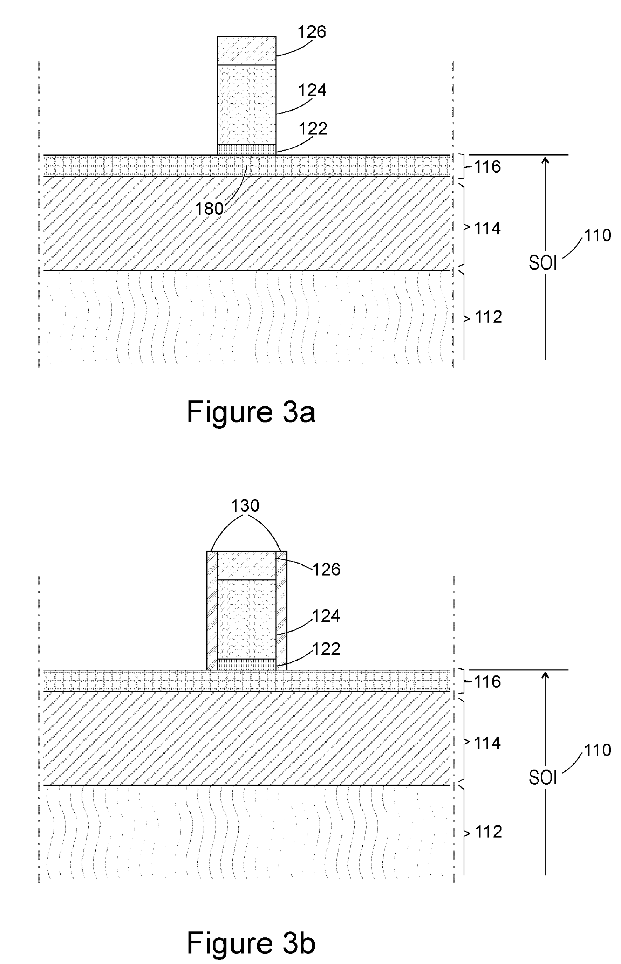

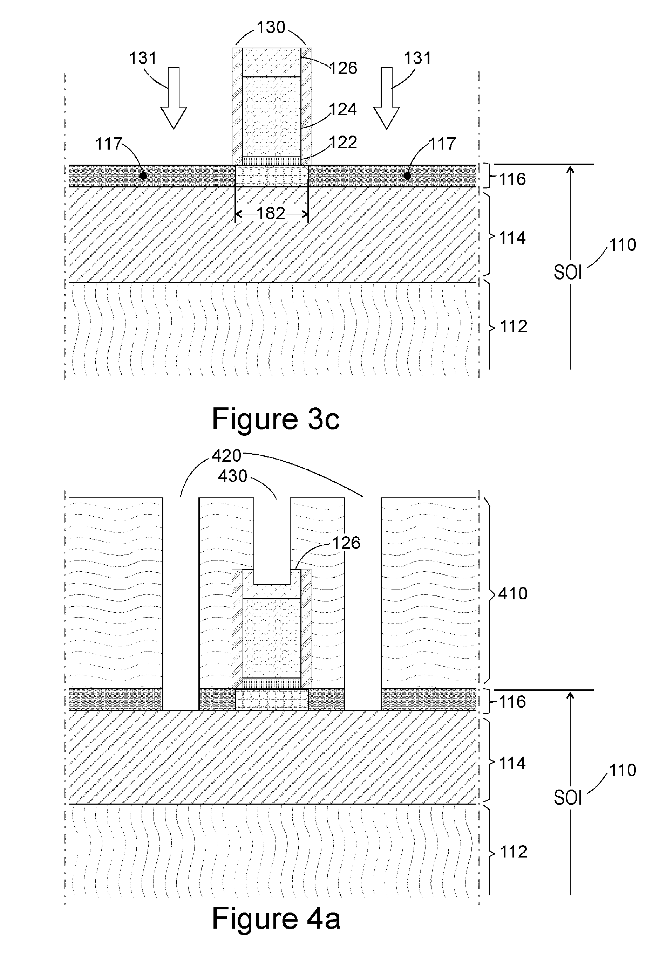

Les **figures 3a à 3c** décrivent des étapes du procédé de l'invention. Ces étapes sont sensiblement identiques à celles du procédé standard de fabrication d'un transistor MOSFET représentatif de l'état de la technique comme celui de la figure 1. Les figures 3a, 3b et 3c correspondent, respectivement, aux étapes 220, 230 et 240 qui ont déjà été brièvement décrites dans le chapitre sur l'état de la technique. Comme déjà mentionné, elles sont précédées d'une étape 210 standard de formation des tranchées d'isolation (STI) qui n'est pas nécessaire à la compréhension de l'invention et qui n'est pas décrite.

Il est précisé que dans le cadre de la présente invention, le terme « sur » « surmonte » ou « sous jacent » ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

La figure 3a montre la structure de grille à l'issue de l'étape 220. On y retrouve la couche 122 d'oxyde de grille et la grille 124, également désignée grille de commande 124. La grille 124 est préférentiellement faite de silicium polycristallin conducteur. C'est en appliquant une tension supérieure à un seuil sur cette grille 124 que l'on va pouvoir créer dans le transistor une fois terminé un canal de conduction 180 dans la partie de la couche active 116 sous jacente, la couche active 116 étant de manière préférée mais non limitative faite en silicium monocristallin. À cette fin, la mince couche d'oxyde de grille 122 est faite d'un matériau diélectrique ayant, de manière préférée mais non limitative, une permittivité relative, encore appelée coefficient diélectrique, élevée.

Selon un mode de réalisation avantageux, la couche active 116 dans laquelle on crée électriquement un canal 180 de conduction sous chaque grille provient d'un substrat de type silicium-sur-isolant (SOI) à partir duquel on réalise le dispositif en cours de fabrication. Selon les modes de réalisation, la couche active 116 aura pu être dopée préalablement, généralement par implantation ionique, pour permettre la fabrication de transistors à canal N où à canal P et pour régler le seuil électrique de conduction mentionné ci-dessus.

Le substrat SOI comprend une couche d'oxyde enterrée 114 sur un substrat homogène 112, généralement une tranche de silicium d'une épaisseur suffisante pour être mécaniquement rigide et ainsi former un ensemble facilement manipulable. Dans la structure de grille de la figure 3a on note à ce stade la présence d'une couche supérieure 126 qui va servir de masque dur de protection à la grille lors des opérations qui vont suivre. Typiquement, les couches de la grille, sont obtenues par dépôt en phase vapeur dans une enceinte confinée de type PVD ou CVD, acronymes de l'anglais « physical vapor deposition » et « chemical vapor deposition » c'est-à-dire, respectivement, dépôt physique ou chimique en phase vapeur. Les motifs et dimensions de grille sont définis d'une façon standard par photolithographie.

La figure 3b montre la structure de grille à l'issue de l'étape 230 de formation des premiers espaceurs 130. Les espaceurs sont obtenus d'une façon standard par un dépôt conforme d'une couche de nitrure de silicium. On entend par dépôt conforme un dépôt dont l'épaisseur est pour l'essentiel indépendante de l'inclinaison des surfaces sur lesquelles il se fait. En particulier, pour la formation des espaceurs, l'épaisseur déposée sur les flancs des motifs de grille est importante. Ce dépôt est suivi d'une gravure fortement anisotrope qui attaque préférentiellement les surfaces horizontales, c'est-à-dire celles qui sont parallèles au plan du substrat 110, ce qui ne laisse du dépôt que les surfaces perpendiculaires couvrant les flancs des motifs de grille. Les espaceurs sont donc réalisés sans opération de photolithographie et se trouvent ainsi auto alignés sur les grilles.

La figure 3c montre la structure du transistor à l'issue de l'étape 240 du procédé où l'on procède à une implantation 131 de la couche superficielle 116 de silicium monocristallin afin d'en inverser le dopage. Dans le cas de la réalisation de transistors dits N MOSFET i.e., à canal P ou de type intrinsèque on procède à l'implantation de dopants de type N, par exemple de l'arsenic (As) ou du phosphore (P). Dans le cas contraire de transistors dits P MOSFET i.e., à canal N ou de type intrinsèque on procède par exemple à l'implantation de bore (B) ou de fluorure de bore (BF₂). L'opération d'implantation se fait sur toute la surface. Le canal des transistors est protégé de l'implantation par la grille et les espaceurs. La grille est elle-même protégée de l'implantation par le masque dur 126 et les espaceurs 130. Le dopage 117 de la couche superficielle 116 définit les zones d'extension de source et de drain qui se trouvent ainsi auto alignés sur la grille. Cette opération définit la longueur 182 du canal 180 dans la couche active, soit la couche superficielle de silicium monocristallin 116 de l'empilement de couche 112, 114, 116 soit dans cet exemple particulier le substrat SOI d'origine.

On notera ici qu'il est courant de réaliser sur une même tranche SOI des transistors complémentaires de façon à produire, par exemple, des circuits logiques de type dit « CMOS », acronyme de l'anglais « complementary metal oxide semiconductor » c'est-à-dire des transistors FET complémentaires, à canal P et à canal N, de structure MOS. Le procédé standard décrit ci-dessus et le procédé de l'invention décrit ci-après sont adaptés simplement en réalisant successivement les deux types de transistors et en répétant les opérations spécifiques aux deux types de transistors sur des zones non masquées obtenues préalablement par photolithographie.

Les **figures 4a à 4e** décrivent les étapes du procédé qui sont spécifiques à l'invention. Le procédé de l'invention diffère notablement du procédé standard en ne procédant pas à une surélévation des zones S/D et donc en ne réalisant pas l'étape de croissance épitaxiale correspondante c'est-à-dire l'étape 250 décrite dans l'état de la technique. Comme on va le voir, pour résoudre le problème de la diminution des résistances d'accès des S/D, le procédé de l'invention s'arrange pour augmenter l'épaisseur de ces zones sous la couche superficielle 116 dans laquelle le canal des transistors est formé ce qui permet d'augmenter cette épaisseur afin de diminuer sa résistance sans augmenter dans le même temps la capacité parasite grille-S/D.

La figure 4a décrit l'opération de formation des contacts sur les électrodes du transistor. Elle se fait en procédant au dépôt d'une couche 410 d'un matériau résistant à l'acide fluorhydrique (HF), acide qui va être ensuite utilisé pour graver l'oxyde de silicium de la couche enterrée 114. Un matériau répondant à ce besoin est par exemple l'oxyde de silicium dopé au carbone (SiOCH) ou le carbone amorphe notamment sous la forme de produits disponibles commercialement connus sous l'acronyme « APF » de l'anglais « advanced patterning film ». On peut par exemple procéder au dépôt de ces matériaux par centrifugation ou par dépôt chimique en phase vapeur assisté par plasma, technique habituellement désignée par l'acronyme PECVD du vocable anglais « plasma enhanced chemical vapor depostion ».

Les motifs de contact 420 pour la source et le drain et 430 pour la grille, sont définis par lithographie et ensuite gravés dans la couche 410 faite, comme on vient de le voir, d'oxyde de silicium dopé au carbone (SiOCH) ou de carbone amorphe (APF). L'arrêt de la gravure de la couche 410 se fait, d'une part, au sommet des grilles, sur le masque dur 126 généralement fait de nitrure de silicium, et d'autre part, dans les zones S/D, jusqu'au silicium de la couche la couche active 116. Cette gravure et les produits de gravure utilisés sont basés sur la chimie du fluorocarbone pour le SiOCH avec des produits de réaction tels que CO, SiF, CFx et HF. Pour le carbone amorphe (APF) c'est la chimie à base d'hydrogène (N₂/H₂, NH₃) qui est par exemple utilisée avec des produits tels que CHx et CN.

Le silicium de la couche active 116 est ensuite gravé avec arrêt sur la couche 114 d'oxyde enterré dans les zones S/D et, au sommet des grilles, sur la couche de masque dur 126 avec, comme illustré, consommation partielle de cette couche. La gravure est de type gravure sèche avec chimie à base de chlore par exemple (HBr/Cl2) ou fluorocarbonée (CF4).

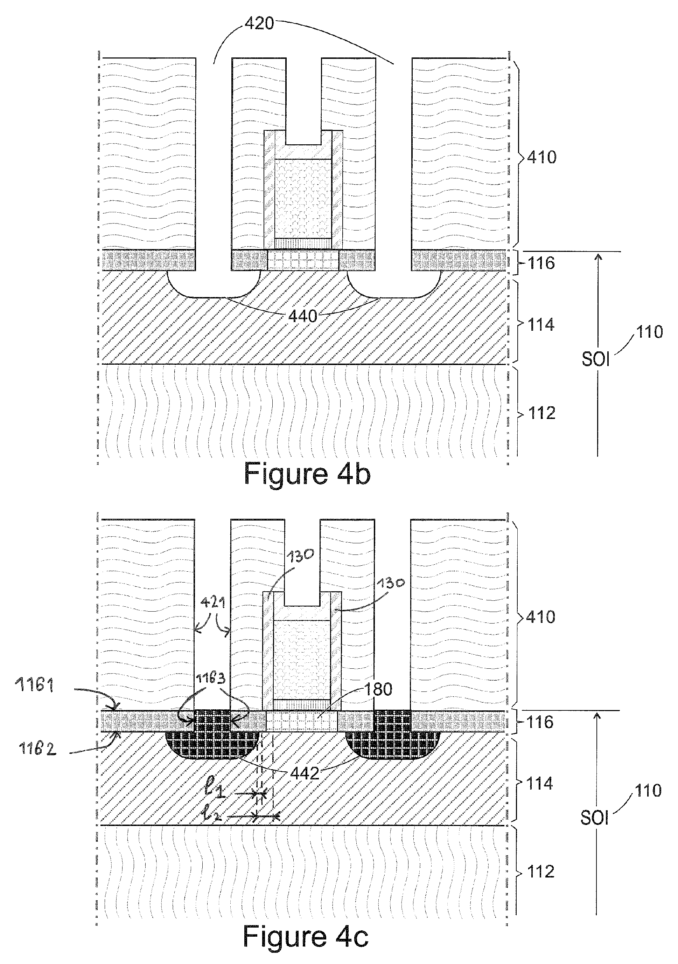

La figure 4b montre la formation de cavités 440 dans la couche enterrée 114 d'oxyde de silicium provenant du substrat SOI d'origine, au fond des contacts S/D 420 qui viennent d'être gravés à travers la couche de protection 410 et la couche active 116. Les cavités 440 sont formées par gravure humide à l'aide d'une solution à base d'acide fluorhydrique (HF) ou avec chimie sèche à base de HF par exemple STI du HF anhydre en bouteille gaz avec Hot N2 en gaz porteur. La concentration en d'acide fluorhydrique de la solution et le temps de gravure sont ajustés en fonction de la consommation d'oxyde de silicium nécessaire à l'obtention de la dimension souhaitée des cavités.

Ces cavités s'étendent en partie au moins sous la couche active 116.

De préférence, la gravure est sélective au SiOCH ou APF et au Si si bien que les couches 410 et 116 restent de forme constante.

De préférence, l'étape de formation d'une cavité dans la couche isolante est réalisée de sorte à former une cavité dont la profondeur, selon une direction perpendiculaire au plan du substrat, profondeur prise à partir de la face inférieure de la couche isolante surmontée de la couche active est comprise entre 1 nm et Tbox-2nm, Tbox étant l'épaisseur de la couche isolante 114. Ainsi, de préférence, les S/D 140 ne traversent pas la couche isolante 114. Ils ne traversent pas toute l'épaisseur de la couche isolante 114. Le fond de la cavité est donc situé dans la couche isolante comme cela apparaît clairement sur les figures. L'invention permet ainsi de conserver une isolation électrique entre les S/D 140 et le substrat 112. De préférence, on fera en sorte que la partie des source et drain qui s'étend de manière isotrope sous les espaceurs ne s'étendent pas au-delà des espaceurs 130, c'est-à-dire que les cavités 440 ne sont pas présentes à l'aplomb des espaceurs 130. En effet, la profondeur est définie par une gravure qui peut être isotrope. Dans ce cas, on a une relation entre largeur et hauteur. Les deux conditions limitantes sont donc : hauteur inférieure à Tbox-2nm et largeur de telle sorte que les SD ne s'étendent pas sous la grille au-delà des espaceurs.

L'extrémité latérale des sources et drain est donc en retrait par rapport à l'aplomb des espaceurs. Une distance I1 prise selon une direction selon une direction perpendiculaire aux flancs de la grille (soit selon l'horizontal sur les figures) représentée sur la figure 4c peut ainsi être définie entre la face externe d'un espaceur 130 et la source ou le drain qui lui est le plus proche.

De même, les source et drain sont en retrait par rapport aux flancs de la grille 120. Une distance I2 prise selon une selon une direction perpendiculaire aux flancs de la grille (soit selon l'horizontal sur les figures) représentée sur la figure 4c peut ainsi être définie entre le flanc de la grille 120 et la source ou le drain qui lui est le plus proche.

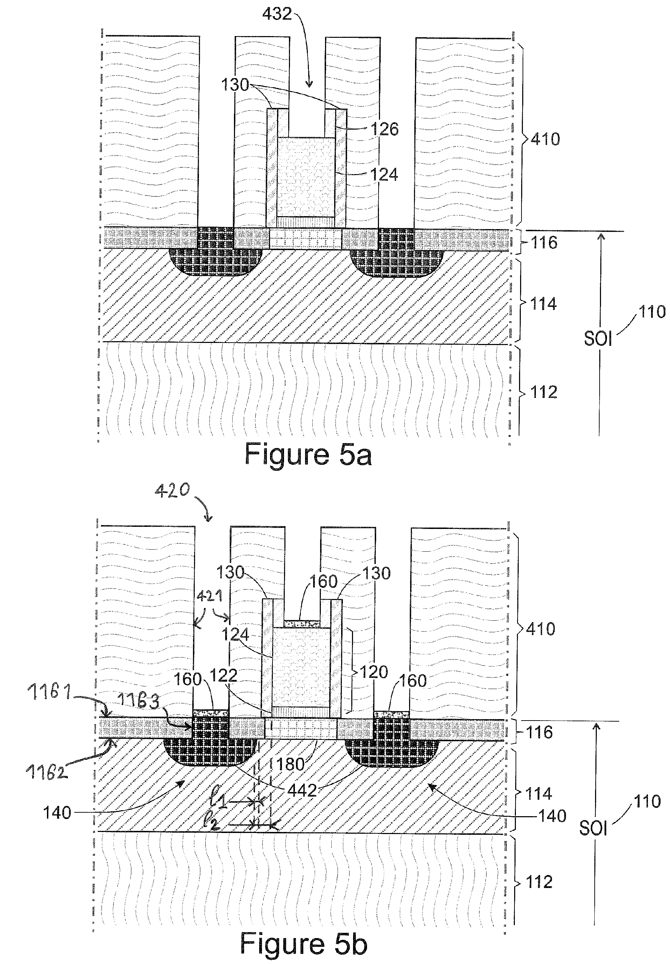

Les distances I1 et I2 sont aussi représentées sur la figure 5b.

La hauteur des sources et drain est de préférence égale à l'épaisseur de la couche active 116 plus la profondeur de la cavité 440 prise à partir de la face inférieure de la couche active 116.

La figure 4c montre le résultat de la croissance épitaxiale qui est ensuite effectuée dans les cavités 440 à partir de la couche active 116, faite typiquement de silicium monocristallin. Le matériau de comblement de la cavité, qui forme les S/D inversés 442, est donc dans cet exemple de réalisation du silicium qui est de préférence dopé in situ, en même temps qu'est réalisée la croissance épitaxiale. Le type de dopage dépend du type des transistors fabriqués, à canal N ou P, et correspond au dopage des zones S/D correspondantes, respectivement, P ou N. On remarque que les S/D surélevés du procédé standard sont ici inversés et remplacés par une croissance épitaxiale, au niveau, et sous la couche active 116 du canal 180. La profondeur et les dimensions des cavités peuvent donc être ajustées pour obtenir une faible résistance d'accès des S/D sans augmenter la capacité parasite entre grille et S/D. On notera ici que la position des cavités sera d'autant mieux maîtrisée que l'ouverture des contacts de S/D sera auto alignée sur la grille.

L'invention permet ainsi de réaliser une source et un drain en dessous de la grille. La source et le drain étant enterrés dans la couche isolante 114, la grille n'a alors plus, ou n'a que peu de surface au regard de la source et du drain selon une direction parallèle au plan du substrat 112, diminuant de ce fait la capacité parasite. En outre, il est parfaitement possible de réaliser une source et un drain de forte épaisseur de sorte à réduire la résistance. L'obtention de la source et du drain repose sur des étapes relativement simples et qui peuvent être reproduites de manière fiable et aisée.

Ainsi, il apparaît clairement que les parois des motifs 420 limitent la croissance des sources et drains 442 selon une direction sensiblement parallèle au plan du substrat 112, c'est-à-dire selon une direction horizontale sur les figures. En effet, les parois 421 des motifs 420 restent en place lors de la croissance des S/D 140. Comme illustré, les S/D 140 ne s'étendent donc pas sur la face supérieure 1161 de la couche active 116. Ils ne recouvrent pas cette dernière. La face supérieure 1161 de la couche active 116 n'est pas recouverte par les S/D 140. Les S/D 140 sont uniquement en contact avec la couche isolante 114 ainsi qu'avec la face inférieure 1162 de la couche active 116 et des parois transversales 1163 de la couche active 116 qui définissent l'épaisseur de cette dernière. Les parois transversales 1163 s'étendent donc dans un plan perpendiculaire au plan du substrat 112 et dans un plan vertical par rapport aux figures 4a à 5b (dans un plan parallèle aux flancs de la grille 120). De manière particulièrement avantageuse, l'absence de matériau formant les S/D recouvrant la couche active 116 permet de réduire la capacité parasite.

La formation des cavités 440 est alors réalisée de manière à graver à la fois la face inférieure 1162 et les parois verticales 1163 de la couche active 116 ainsi que la couche isolante 114, de préférence sur une partie seulement de son épaisseur.

Comme illustré sur les figures 4c à 5b, les cavités sont entièrement remplies lors du remplissage. Ainsi, et comme représenté sur les figures, pour leur partie située sous la face inférieure 1162 de la couche active 116, les source et drain 140 sont, sur toute leur surface, au contact de la couche isolante 114.

Si l'épitaxie précédente est non dopée, le dopage des zones S/D inversées est réalisé ensuite, par exemple, par implantation ionique. Comme mentionné précédemment, dans le cas de réalisation de transistors complémentaires à canal P et N, les deux types de transistors sont réalisés successivement en masquant par photolithographie les zones de transistors de type opposé. Le dopage des zones S/D inversées par implantation requière ensuite qu'un recuit de diffusion des dopants soit pratiqué. Cette opération est aussi avantageuse dans le cas où le dopage est effectué in situ pendant la croissance épitaxiale inversée.

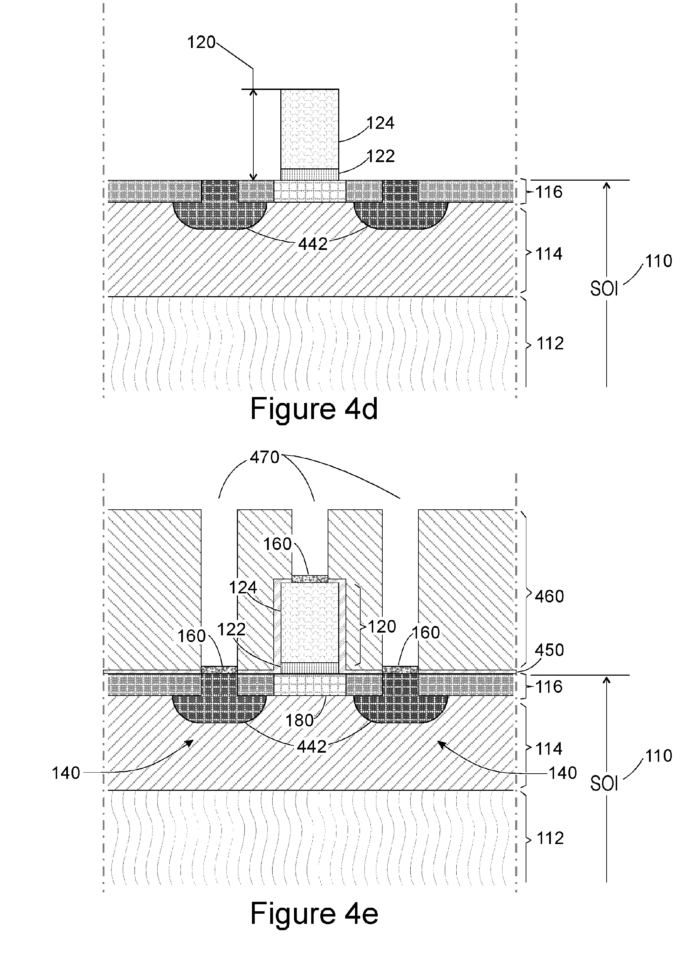

La figure 4d décrit l'étape du procédé de l'invention où l'on procède à l'enlèvement de la couche de protection 410 faite d'oxyde de silicium dopé au carbone (SiOCH) ou de carbone amorphe (APF). On notera donc qu'avantageusement le couche de protection 410 est conservée pendant l'étape de remplissage des cavités comme cela apparaît en figure 4c, permettant ainsi de limiter l'extension des zones de source et drain 140 au dessus de la couche active 116 ce qui permet de limiter encore plus les capacités parasites.

Pour l'enlèvement de la couche de protection 410, dans le cas du SiOCH on procède par gravure plasma et plus particulièrement à l'aide d'une technique dite de « plasma délocalisé » dans laquelle le plasma est formé dans une chambre séparée de celle où la gravure est réalisée afin de pouvoir éliminer certaines des particules générées pour qu'elles n'endommagent pas la surface de la tranche. La gravure plasma à pour but dans ce cas de transformer l'oxyde de silicium dopé au carbone (SiOCH) en oxyde de silicium (SiO₂ qui est ensuite enlevé sélectivement à l'aide d'une solution à base d'acide fluorhydrique (HF). Dans le cas de l'APF le retrait se fait également à l'aide d'un plasma à base d'oxygène.

Le nitrure des espaceurs et le masque dur 126, généralement fait de nitrure, sont également enlevés à l'aide d'un nettoyage humide le plus souvent désigné par le vocable anglais de « wet clean »

Après ces opérations la grille 120 ne comporte plus que les deux couches essentielles au fonctionnement du dispositif : l'oxyde de grille 122 et l'électrode de commande de grille 124 faite de silicium polycristallin. Les source et drain inversés 442 qui ont été formés dans les cavités de la couche d'oxyde enterrée sont présents de part et d'autre de la grille.

La figure 4e décrit l'étape de formation des contacts sur les électrodes du transistor. Cette étape peut être réalisée par des techniques connues de l'homme du métier. De préférence, au cours de cette étape on procède d'abord au dépôt d'une couche d'arrêt 450, typiquement faite de nitrure de silicium, puis d'une couche de protection 460 préférentiellement en oxyde de silicium. La couche de nitrure de silicium sert de couche d'arrêt pendant la gravure de l'oxyde de silicium 460. Cette couche est cependant optionnelle et sert seulement à limiter la consommation de Si pendant l'étape de gravure du SiO2, la sélectivité SiN /Si étant meilleure que celle SiO2/Si. C'est dans ces couches d'isolation des transistors que l'on va ouvrir 470 à nouveau les contacts de grille et des source et drain après qu'une planarisation de la surface aura été effectuée afin que les nombreuses couches métalliques (non représentées) nécessaires à l'interconnexion des transistors demeurent les plus planes possibles. L'opération de planarisation consiste par exemple en un polissage de la tranche de type CMP, acronyme de l'anglais « chemical mecanical polishing » c'est-à-dire « polissage mécano chimique ». Après avoir été défini par photolithographie les zones de contact sont alors gravées à travers la couche d'oxyde 460 et celle de nitrure 450 jusqu'au silicium polycristallin de la grille 124 et jusqu'au silicium des S/D inversés 442. Comme dans le procédé standard, on peut alors procéder à une siliciuration 160 des zones de contact afin d'assurer un bon contact électrique avec le silicium sous jacent.

On notera que dans cette mise en oeuvre de l'invention on peut aussi procéder à la siliciuration des contacts avant retrait de la couche 410 d'oxyde de silicium dopé au carbone (SiOCH). Dans ce cas la gravure des contacts s'arrêtera sur un siliciure de silicium qui peut présenter une meilleure sélectivité de gravure que le silicium et on procédera au préalable au retrait du masque dur 126, généralement fait de nitrure de silicium, situé au sommet de la grille comme dans l'étape correspondant à la figure 5a décrite ci-après.

Les **figures 5a et 5b** décrivent une autre variante de mise en oeuvre du procédé de l'invention.

La figure 5a montre le cas où, après l'étape correspondant à la figure 4c, c'est-à-dire l'étape de croissance épitaxiale pour remplir les cavités, on conserve la couche 410 d'oxyde de silicium dopé au carbone (SiOCH) qui remplace alors l'oxyde de silicium (SiO₂) traditionnellement utilisé pour la réalisation des contacts. On fait ainsi l'économie de l'étape correspondant à la figure 4d où l'on procède à l'enlèvement du SiOCH et aux étapes de dépôt d'une couche de nitrure 450 et de la couche d'oxyde de silicium 460, étapes suivies d'une nouvelle ouverture 470 des contacts comme montré sur la figure 4e. On notera que les espaceurs 130 en nitrure restent alors en place. Dans cette variante de mise en oeuvre de l'invention l'épitaxie inversée dans les cavités 440 est préférentiellement dopée in situ. En effet, n'ayant pas accès aux zones de silicium proches des espaceurs qui sont recouvertes par le SiOCH qu'on laisse en place, on ne peut donc pas venir implanter des dopants à proximité de ces derniers. On peut en revanche les diffuser à partir de l'épitaxie dopée in situ qui se rapproche des bords des espaceurs.

À l'étape correspondant à la figure 5a, on procède donc essentiellement à l'ouverture 432 des contacts de grille par gravure sèche ou humide de la couche restante du masque dur 126 situé au sommet des grilles de façon à pouvoir accéder au silicium polycristallin de la grille de commande 124.

Comme montré sur la figure 5b on peut alors procéder comme précédemment à la siliciuration 160 de toutes les zones de contact.

L'avantage de conserver la couche de protection 410 ou 460 lorsque la structure finale est réalisée, est que dans ce cas les trous de contact sont déjà réalisés. Avec les procédés conventionnels, cette étape de réalisation des contacts nécessite un contrôle de la gravure s'arrêtant sur le siliciure. L'invention, en conservant les couches 460 et 410 permet de relâcher les contraintes sur la réalisation des contacts.

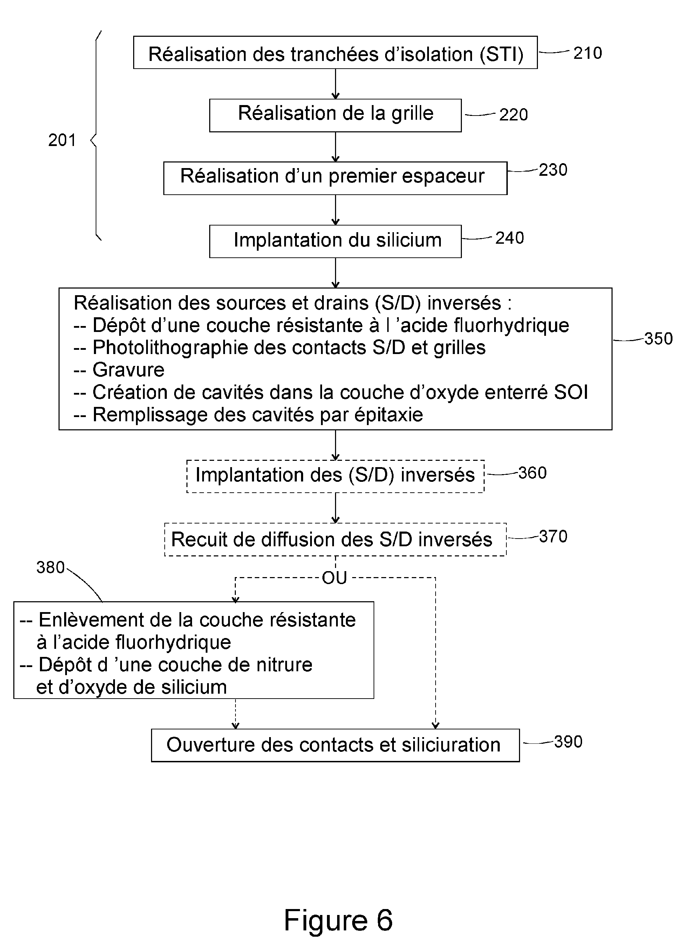

La **figure 6** résume les principales étapes de fabrication d'un transistor selon le procédé de l'invention.

Les étapes préliminaires 201 jusqu'à l'implantation de la couche superficielle de silicium 116 sont les mêmes que celles du procédé standard. Il s'agit des étapes 210, 220, 230 et 240 qui ont été décrites dans les figures 3a à 3c. Le procédé de l'invention concerne les étapes 350, 360, 370, 380 et 390.

Comme on l'a vu dans les figures 4a à 4e, l'étape 350 consiste à créer les S/D inversés en les faisant croître par épitaxie dans des cavités préalablement creusées dans la couche isolante, typiquement la couche d'oxyde enterrée d'un substrat SOI d'origine. La création des cavités requière qu'une couche de protection des grilles, résistante à l'acide fluorhydrique (HF), soit déposée qui va permettre, après gravure des motifs de contact, la formation des cavités. Le silicium épitaxial est de préférence dopé in situ lors de la croissance des S/D inversés.

L'étape 360 d'implantation des S/D inversés est optionnelle. Elle est avantageuse si le dopage in situ lors de la croissance épitaxiale n'a pas été effectué. L'implantation induisant des défauts qui peuvent être plus difficiles à guérir sur film mince que sur silicium massif, l'épaisseur du germe monocristallin non endommagé pouvant alors être faible voire nulle, et en fonction des modes de mise en oeuvre de l'invention, le dopage in situ pourra être préféré à l'implantation.

Une étape 370 optionnelle de recuit de diffusion des dopants qui ont été possiblement implantés à l'étape précédente est ensuite effectuée. Le recuit peut aussi s'appliquer dans le cas où le dopage a été effectué in situ lors de la croissance épitaxiale. On notera ici qu'une variante du procédé de fabrication consiste à ce que le recuit de l'étape 370 serve aussi à contrôler l'extension des zones S/D qui vont définir la longueur du canal du transistor sous la grille. Cette opération peut alors remplacer l'étape standard 240 d'implantation du silicium décrite précédemment simplifiant ainsi le procédé de fabrication de l'invention.

L'étape suivante 380 concerne la variante du procédé décrite dans les figures 4a à 4e où l'on procède à l'enlèvement de la couche 410 résistante à l'acide fluorhydrique pour la remplacer par une couche d'isolation 460 faite d'oxyde de silicium dans laquelle seront réalisés l'ouverture des contacts et leur siliciuration à l'étape 390.

On peut aussi, comme expliqué dans les figures 5a et 5b, laisser en place la couche résistante à l'acide fluorhydrique et l'utiliser fonctionnellement. C'est en particulier possible si la couche est faite de silicium dopé au carbone (SiOCH). Dans ce cas, après l'étape 350 et, possiblement, après les étapes optionnelles 360 et 370 on passe alors directement à l'étape 390 où l'on procède à l'ouverture 432 des contacts non encore ouverts, c'est-à-dire ceux de grille, et à la siliciuration 160 de tous les contacts.

On remarquera enfin que parmi les avantages du procédé de l'invention la hauteur de grille n'est plus dépendante de la hauteur 140 des S/D surélevés du procédé standard. En effet, comme illustré sur la figure 1, il est en général requis que le contact de grille doive être situé plus haut que les contacts S/D ce qui oblige à avoir une hauteur 120 de grille importante et augmente d'autant la capacité parasite grille-S/D 190. Cette hauteur 120 comprend la hauteur de la grille 124 et de l'oxyde de grille 122. Au contraire, avec le procédé de l'invention, les S/D inversés étant situés sous le niveau du canal, dans l'oxyde enterré 114, on devient libre d'ajuster la hauteur de grille indépendamment de la hauteur des S/D surélevés. Cela facilite non seulement la mise en oeuvre du procédé standard le plus couramment utilisé par l'industrie de la microélectronique, celui décrit précédemment où c'est la grille qui est réalisée en premier (« gate-first » dans la littérature technique en anglais sur le sujet), mais aussi la mise en oeuvre de procédés moins courants tel que celui où l'on réalise la grille en dernier (« gate last »), typiquement après les étapes de formations des sources et drains. Dans ce cas, le contact de grille est obtenu par une technique dite de damasquinage nécessitant un polissage de type CMP. Ainsi, la présente invention permet avantageusement de pouvoir réaliser la grille en dernier, ce qui évite de soumettre la grille à des contraintes thermiques par exemple et liées à la fabrication des autres éléments du transistor, ce qui permet par conséquent de préserver le budget thermique de la grille.

On remarquera aussi que le procédé de l'invention ne requière pas spécifiquement l'usage d'espaceur pour les source et drain. Le contact peut donc être plus proche de la grille. On peut alors supprimer la siliciuration planaire utilisée par le procédé standard et la remplacer par une siliciuration de fond de contact. La suppression des espaceurs de SD autorise une diminution du pas de répétition des grilles et permet donc d'obtenir une augmentation de densité correspondante.

L'invention n'est pas limitée aux modes de réalisation précédemment décrits mais s'étend à tout mode de réalisation conforme à son esprit. Notamment, l'invention s'étend aussi aux empilements de couches non formées par un substrat de type SOI.

## Revendications

1. Procédé de fabrication d'un transistor comprenant la préparation d'un empilement de couches comportant au moins un substrat (142) surmonté d'une couche isolante (144) et d'une couche active (146) destinée à former un canal (180) pour le transistor, le procédé comprenant en outre la préparation d'une source et d'un drain (140), le procédé étant **caractérisé en ce que** la préparation de la source et du drain (140) comprend:
le dépôt d'une couche de protection (410) recouvrant au moins la couche active (116);
la formation d'ouvertures (420) à travers la couche de protection (410) et la couche active (116) pour mettre à nu la couche isolante (144) au niveau de zones destinées à former la source et la drain (140);
la formation d'une cavité (440) dans la couche isolante (114) au fond des ouvertures (420);
le remplissage des cavités (440) par un matériau semi-conducteur, la couche de protection (410) étant conservée lors du remplissage des cavités (440).

2. Procédé selon la revendication précédente dans lequel l'étape de formation d'une cavité (440) dans la couche isolante (114) est réalisée de sorte à former une cavité (440) dont la profondeur, selon une direction perpendiculaire au plan du substrat (112) est comprise entre un nanomètre et une épaisseur égale à l'épaisseur de la couche isolante (114) moins deux nanomètres, l'épaisseur étant prise à partir d'une face inférieure de la couche active (116) et selon une direction perpendiculaire au plan du substrat (112).

3. Procédé selon l'une quelconque des deux revendications précédentes dans lequel la couche active (116) est faite d'un matériau semi-conducteur et le remplissage des cavités (440) est effectué par épitaxie de la couche active (116).

4. Procédé selon l'une quelconque des trois revendications précédentes dans lequel la formation des cavités (440) est effectuée de manière à ce que le fond de la cavité soit située dans la couche isolante et à ce que les extrémités latérales de la cavité soient distantes de l'aplomb des flancs de la grille.

5. Procédé selon la revendication précédente dans lequel on procède à la siliciuration de contacts (390) au niveau de la source et du drain (140).

6. Procédé selon l'une quelconque des revendications 1 à 5 dans lequel la couche de protection (410) est conservée au cours de toutes les étapes du procédé.

7. Procédé selon l'une quelconque des revendications 1 à 5 comprenant en outre après l'étape de remplissage des cavités (440) par un matériau semi-conducteur:
- l'enlèvement (380) de la couche de protection (410) ;
- le dépôt d'au moins une couche d'isolation électrique (450, 460) ;
- l'ouverture de zones de contact (470) au moins au niveau de la source et du drain (140) à travers ladite au moins une couche d'isolation électrique (450,460).

8. Procédé selon l'une quelconque des revendications 1 à 7 dans lequel on procède à un dopage de la source et du drain, le dopage étant effectué in situ lors du remplissage des cavités ou à l'aide d'une implantation ionique (360) après l'étape de remplissage des cavités.

9. Procédé selon l'une quelconque des revendications 1 à 8 dans lequel on pratique un recuit de diffusion (370) de la source et du drain (140).

10. Procédé selon l'une quelconque des revendications 1 à 9 dans lequel l'empilement de couches comprenant le substrat (112), la couche isolante (114) et la couche active (116) est un substrat de type semi-conducteur sur isolant.

11. Procédé selon l'une quelconque des revendications 1 à 10 dans lequel le matériau constituant la couche de protection est de l'oxyde de silicium dopé au carbone (SiOCH) ou du carbone amorphe (APF).

12. Procédé selon l'une quelconque des revendications 1 à 11 dans lequel la préparation de la source et du drain (140) est effectuée après une étape de formation d'une grille (124) de commande du transistor ou avant une étape de formation d'une grille (124) de commande du transistor, la grille étant formée de sorte à surmonter la couche active (116).

13. Transistor comprenant au moins : une couche active (116) formant un canal (180) pour le transistor, une couche isolante (114) disposée au regard d'une face inférieure de la couche active (116), une grille (124) tournée au regard d'une face supérieure de la couche active (116) et une source et un drain (140) disposés de part et d'autre de la grille (124), **caractérisé en ce qu'**au moins l'un parmi la source et le drain (140) s'étend au moins partiellement à travers la couche active (116) et dans des cavités (440) de la couche isolante (114), de manière à remplir entièrement ces cavités (440) et **en ce que** le transistor comprend une couche de protection (410, 460) recouvrant la couche active (116) et la grille (124) à l'exception de zones de contact électriques.

14. Transistor selon la revendication précédente dans lequel l'au moins un parmi la source et le drain (140) qui traverse la couche active (116) et s'étend dans la couche isolante (114) depuis la face supérieure de la couche active (116) présente une épaisseur comprise entre 1 nanomètre et une épaisseur égale à l'épaisseur de la couche isolante (114) moins deux nanomètres, l'épaisseur étant prise selon une direction perpendiculaire au plan d'un substrat (112) sur lequel repose la couche active (116) et la couche isolante (114).

15. Transistor selon l'une quelconque des deux revendications précédentes dans lequel la face supérieure de l'au moins un parmi la source et le drain (140) est entièrement située en dessous d'une face inférieure de la grille (124).
